(19)

Europäisches Patentamt
European Patent Office
Office européen des brevets

(11) **EP 2 852 028 A1**

(12) **EUROPEAN PATENT APPLICATION**
published in accordance with Art. 153(4) EPC

(43) Date of publication:
**25.03.2015 Bulletin 2015/13**

(21) Application number: **13791370.3**

(22) Date of filing: **14.05.2013**

(51) Int Cl.:
**H02J 17/00** *(2006.01)*    **H01F 38/14** *(2006.01)*
**H01Q 7/00** *(2006.01)*    **H02J 7/00** *(2006.01)*
**H05K 9/00** *(2006.01)*

(86) International application number:
**PCT/JP2013/063435**

(87) International publication number:
**WO 2013/172349 (21.11.2013 Gazette 2013/47)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **14.05.2012   JP 2012110940**

(71) Applicant: **Hitachi Chemical Company, Ltd.
Chiyoda-ku
Tokyo 100-6606 (JP)**

(72) Inventors:
- **ENDOU Toshihiro
  Chikusei-shi
  Ibaraki 308-8524 (JP)**
- **KOBAYASHI Kazuhito
  Tsukuba-shi
  Ibaraki 300-4247 (JP)**
- **OOTA Masahiko
  Tokyo 100-6606 (JP)**

(74) Representative: **Hoffmann Eitle
Patent- und Rechtsanwälte PartmbB
Arabellastraße 30
81925 München (DE)**

(54) **ANTENNA SHEET FOR CONTACTLESS CHARGING DEVICE AND CHARGING DEVICE USING SAID SHEET**

(57)    Provided are an antenna sheet for a non-contact charging device and a charging device using the antenna sheet. The antenna sheet is configured to allow for a high degree of freedom in respect of arrangement of a transmitting side and a receiving side during power charging. The antenna sheet is an antenna sheet for a non-contact charging device, and is usable as a transmitting-side resonator for a transmitting-side device or a receiving-side resonator for a receiving-side device. The antenna sheet comprises: a substrate; and a coil-shaped antenna formed on the substrate, wherein the coil-shaped antenna is configured to function as a pickup coil operable to resonate at a resonant frequency f, when a resonance capacitor is set to have a capacitance C. The resonant frequency (f) is 13.56 MHz, the transmitting-side resonator comprises a resonance capacitor having a capacitance of 1 to 5 pF, and the receiving-side resonator comprises a resonance capacitor having a capacitance of 70 to 100 pF.

FIG.5B

EP 2 852 028 A1

## Description

TECHNICAL FIELD

The present invention generally relates to a non-contact charging device for transmitting electricity from a feeder/charger side to a battery/terminal side in a non-contact manner, and, in particular, to an antenna sheet for a non-contact charging device for feeding electricity through a magnetic field coupling and a charging device using the antenna sheet.

BACKGROUND ART

Charging with respect to a secondary battery usable for an electric source of a device, such as a mobile phone, a mobile terminal, an electric shaver, or an electric toothbrush, has heretofore been performed by causing current to flow by an electrically-conductive contact between a contact point of a charger and a device-side contact point wired from a battery pack serving as the secondary battery.

In recent years, there has been increased a type which performs charging with respect to the secondary battery of such a device or the like in a non-contact manner.

The Patent Document 1 discloses a non-contact charging device for feeding electricity in a non-contact state by electromagnetic induction action. The device has a power transmitting side and a power receiving side each comprising a plurality of coils arranged on a plate-like soft magnetic material, wherein the coils on the power transmitting side and the coils on the power receiving side are arranged in a spaced-apart and opposed relation so as to allow magnetic fluxes generated by adjacent coils on each side to be respectively directed in reverse directions, and wherein the plate-like soft magnetic material on the power receiving side is arranged to come contact with a battery can directly or via an insulating member.

In addition, the Patent Document 2 describes a non-contact power transmission device for feeding electricity from power transmission coils to power reception coils by electromagnetic induction. The device is capable of preventing occurrence of a leakage magnetic flux, and of accommodating battery charges for a plurality of electronic devices having different electricity requirements by a single power transmission device. The device comprises a plurality of power transmission coils 11, 12 arranged in an approximately concentric pattern, and is configured to drive only a power transmission coil having an outer shape closest to an outer shape of a power reception coil 21 and a power transmission coil arranged thereinside. Accordingly, the device provides an effect of preventing an occurrence of the leakage magnetic flux even when the electricity is transmitted to the power reception coils having different outer shapes by a single power transmission device.

However, such a non-contact type charging device or power transmission device performs charging or power transmission through electromagnetic coupling involved with electromagnetic induction action, so that the arrangement on the power transmitting and receiving sides is limited. That is, there has been a problem that the charging efficiency becomes extremely degraded unless the power transmission coils and the power reception coils are arranged in an approximately opposed relation at an extremely close range.

On the other hand, yet among the non-contact type charging device, there is a device which feeds electricity on a charger side to a rechargeable battery side by a magnetic field coupling of a primary coil (power transmission coil) and a secondary coil (power reception coil) (the Patent Document 3).

Specifically, the Patent Document 3 discloses a non-contact charging device comprising: a charger 1; and a wireless communication device 2 having a charging battery 210. The charger 1 is provided with a primary coil 103 and means 104, 105 for feeding AC power to the primary coil. The wireless communication device 2 is provided with a secondary coil 212 in magnetic field coupling with the primary coil 103, and means 211 for using an electromotive force generated in the secondary coil as charging power for the charging battery 210. The non-contact charging device is configured to perform charging by feeding the electricity of the charger 1 to the charging battery 210 through magnetic field coupling between the primary coil 103 and the secondary coil 212. The non-contact charging device is provided with switches 106, 107, 213 for stopping the feeding of electricity to the primary coil 103, and when it is required to make or receive a call during charging of the wireless communication device, the switches are operated to stop the charging to eliminate an influence of a magnetic force exerted on the wireless communication device, thereby allowing the wireless communication device to be lifted up from the charger by a slight force and used.

However, as described above, the device disclosed in the Patent Document 3 is required, when it is required to make or receive a call during charging of the wireless communication device, to stop the charging to eliminate an influence of a magnetic force exerted on the wireless communication device, allowing the wireless communication device to be lifted up from the charger by a slight force because the magnetic force between the primary coil and the secondary coil is extremely large.

Further, the charger 1 has a concave portion provided in a base case for feeding electricity to the wireless communication device, in which the wireless communication device can be inserted. The concave portion is configured to allow the wireless communication device to be placed on the charging device in a standing state, and thus, the arrangement relation between the power transmitting side and the power receiving side is limited.

LIST OF PRIOR ART DOCUMENTS

[PATENT DOCUMENTS]

Patent Document 1: JP 11-103531 A

Patent Document 2: JP 2012-060812A

Patent Document 3: JP 08-019185A

SUMMARY OF THE INVENTION

[TECHNICAL PROBLEM]

It is therefore an object of the present invention to provide an antenna sheet for a non-contact charging device and a charging device using the antenna sheet, wherein the antenna sheet is configured to allow for a high degree of freedom in regard to the arrangement of a charger side and a battery side during power charging.

[SOLUTION TO THE PROBLEM]

According to the present invention, there is provided an antenna sheet for a non-contact charging device, usable as a transmitting-side resonator for a transmitting-side device or a receiving-side resonator for a receiving-side device, the antenna sheet comprising: a substrate; and a coil-shaped antenna formed on the substrate, the coil-shaped antenna being configured to function as a pickup coil operable to resonate at a resonant frequency f, when a resonance capacitor is set to have a capacitance C.

In the antenna sheet, the resonant frequency f is 13.56 MHz, the transmitting-side resonator comprises a resonance capacitor having a capacitance of 1 to 5 pF, and the receiving-side resonator comprises a resonance capacitor having a capacitance of 70 to 100 pF.

In the antenna sheet, the resonant frequency f is 6.78 MHz, the transmitting-side resonator comprises a resonance capacitor having a capacitance of 8 to 20 pF, and the receiving-side resonator comprises a resonance capacitor having a capacitance of 70 to 120 pF.

According to the present invention, there is also provided a non-contact charging device comprising: a transmitting-side antenna sheet obtained by adhering a first substrate on a first magnetic sheet with an adhesive, forming a resonance coil on the first substrate, and burying a feed coil in the adhesive; and a receiving-side antenna sheet obtained by adhering a second substrate on a second magnetic sheet with an adhesive, and forming a reception coil on the second substrate.

In the non-contact charging device, each of the resonance coil and the reception coil has a resonant frequency of 13.56 MHz, the transmitting-side antenna sheet comprises a resonance capacitor having a capacitance of 1 to 5 pF, and the receiving-side antenna sheet comprises a resonance capacitor having a capacitance of 70 to 100 pF.

In the non-contact charging device, each of the resonance coil and the reception coil has a resonant frequency of 6.78 MHz, the transmitting-side antenna sheet comprises a resonance capacitor having a capacitance of 8 to 20 pF, and the receiving-side antenna sheet comprises a resonance capacitor having a capacitance of 70 to 120 pF.

[EFFECT OF THE INVENTION]

The present invention provides an effect that there can be provided an antenna sheet for a non-contact charging device and a charging device using the antenna sheet, wherein the antenna sheet is configured to allow for a high degree of freedom in regard to the arrangement of a charger side and a battery side during power charging, and further, that electricity on the transmitting side can be simultaneously fed to a plurality of devices on the receiving side.

## BRIEF DESCRIPTION OF THE DRAWINGS

FIG. 1 is an explanation view illustrating in a perspective view a configuration of a non-contact charging device according to one embodiment of the present invention.

FIG. 2A is an explanation view illustrating a cross-section structure of an antenna sheet for the non-contact charging device (receiving side) according to one embodiment of the present invention.

FIG. 2B is an explanation view illustrating a cross-section structure of an antenna sheet for the non-contact charging device (transmitting side) according to one embodiment of the present invention.

FIG. 2C is an explanation view illustrating a cross-section structure of the antenna sheet for the non-contact charging device (transmitting side) according to other embodiment of the present invention.

FIG. 3 is an explanation view illustrating a planar structure of the antenna sheet for the non-contact charging device according to other embodiment of the present invention.

FIG. 4 is an explanation view illustrating a cross-section structure of a magnetic sheet for use in the antenna sheet for the non-contact charging device (receiving side) according to one embodiment of the present invention.

FIG. 5A is an explanation view illustrating an exterior configuration of the non-contact charging device according to one embodiment of the present invention.

FIG. 5B is an explanation view illustrating an exterior configuration of the non-contact charging device according to other embodiment of the present invention.

FIG. 6 is an explanation view illustrating a cross-section structure of the antenna sheet for the non-contact charging device according to other embodiment of the present invention.

FIG. 7 is an explanation view illustrating a cross-section structure of the non-contact charging device according to other embodiment of the present invention.

FIG. 8A is an explanation view illustrating an exterior configuration of the non-contact charging device according to other embodiment of the present invention.

FIG. 8B is an explanation view illustrating an exterior configuration of the non-contact charging device according to other embodiment of the present invention.

FIG. 9A is an explanation view illustrating a planar structure of the antenna sheet for the non-contact charging device according to other embodiment of the present invention.

FIG. 9B is an explanation view illustrating a detailed structure of the antenna sheet for the non-contact charging device according to FIG. 9A.

FIG. 10 is an explanation view illustrating a variation in attachment positions and sizes of the magnetic sheet with respect to the antenna sheet for the non-contact charging device (receiving side) according to one embodiment of the present invention.

FIG. 11 is an explanation view illustrating a broad range of degree of freedom of sheet arrangements in the non-contact charging device according to other embodiment of the present invention.

FIG. 12 is an explanation view illustrating an example in which one or several transmitting-side devices are used according to the present invention.

## DESCRIPTION OF EMBODIMENTS

Embodiments of an antenna sheet for a non-contact charging device and a charging device using the antenna sheet according to the present invention will now be described with reference to the figures.

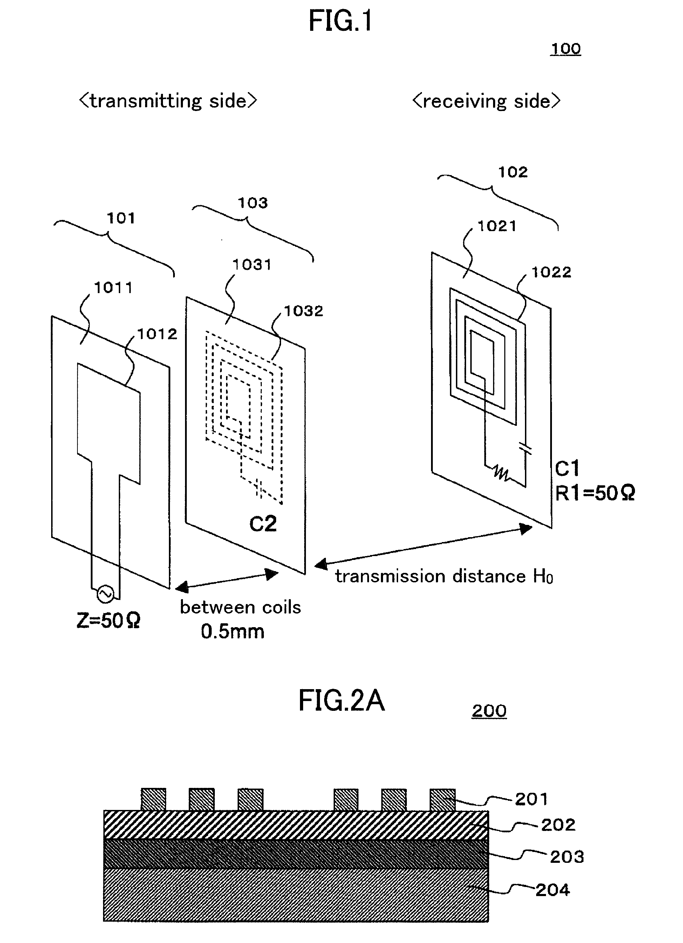

FIG. 1 illustrates a perspective view of a configuration of a non-contact charging device according to one embodiment of the present invention. A non-contact charging device 100 comprises a feed sheet 101, a reception sheet 102 and a resonance sheet 103, wherein each of the sheets comprises a substrate and a coil. That is, as an example, the feed sheet 101 comprises a substrate 1011 and a feed coil 1012 formed on the substrate 1011, the reception sheet 102 comprises a substrate 1021 and a reception coil 1022 formed on the substrate 1021, and the resonance sheet 103 comprises a substrate 1031 and a resonance coil 1032 formed on the substrate 1031.

Hereinafter, the feed sheet 101, the reception sheet 102 and the resonance sheet 103 are also referred to as a feeding antenna sheet 101, a receiving antenna sheet 102 and a resonating antenna sheet 103, respectively.

Further, the feed coil 1012, the reception coil 1022 and the resonance coil 1032 are also referred to as a feed antenna 1012, a reception antenna 1022 and a resonance antenna 1032, or as feed coil-shaped antenna 1012, a reception coil-shaped antenna 1022 and a resonance coil-shaped antenna 1032, respectively.

In the non-contact charging device in FIG. 1, polyimide or glass epoxy may be used for the material of each substrate. Further, copper or aluminum may be employed for the material of coil-shaped antennas. Furthermore, each coil-shaped antenna may be formed by etching on the substrate.

Each coil-shaped antenna formed on the substrate has a role of transmitting electricity fed from a feeding device (not illustrated) from a transmitting side to a receiving side. In FIG. 1, as one embodiment, the feed coil 1012 has an impedance of 50 Ω, the reception coil 1022 has a capacitance of C1, and the resonance coil 1032 has a capacitance of C2 (variable). Each of C 1 and C2 takes a variable value depending on a design of the charging device. The reception coil 1022 has a resistance value R1 of 50 Ω.

In the non-contact charging device in FIG. 1, the feed coil 1012 and the resonance coil 1032 are designed to have a spacing of 0.5 mm therebetween. A transmission distance H enables efficient charging even with a significant degree of freedom as described below. Further, although not illustrated in FIG. 1, a magnetic sheet may be used for the antenna sheet for the non-contact charging device according to the present invention, as described below.

FIG. 2A illustrates a cross-section structure of an antenna sheet for the non-contact charging device (receiving side) according to one embodiment of the present invention. As illustrated in FIG. 2A, an antenna sheet for the non-contact charging device 200 comprises, as the constructional members thereof, a reception coil (-shaped antenna) 201, a substrate 202 and a magnetic sheet 204. More specifically, the antenna sheet 200 comprises the substrate 202 adhered on the magnetic sheet 204 with an adhesive 203, and the reception coil (-shaped antenna) 201 formed on the substrate 202 by etching or the like.

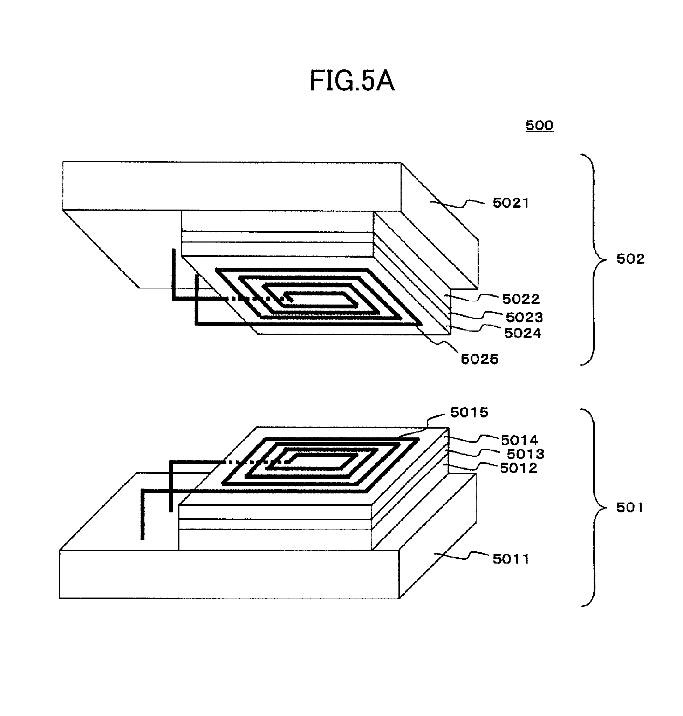

The antenna sheet 200 may also be used as an antenna sheet on the transmitting side (as described below in FIG. 5A and the description associated therewith).

For the adhesive 203, it is possible to use a thermoplastic resin such as vinyl acetate or vinyl chloride, or a solvent having a thermoplastic resin component.

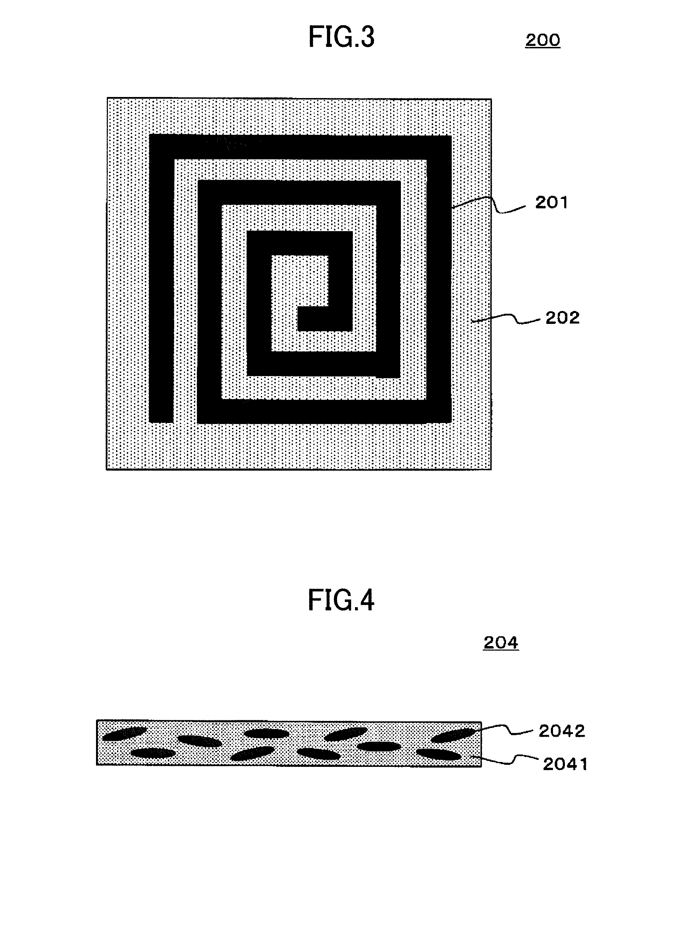

For the magnetic sheet 204, it is possible to use a magnetic sheet comprising a flat soft magnetic material powder and a resin. FIG. 4 illustrates a detailed structure of the magnetic sheet 204. In FIG. 4, the magnetic sheet 204 is formed from a mixture of a matrix resin 2041 with a flat soft magnetic material powder 2042. For the magnetic sheet 204, various magnetic sheets comprising a flat soft magnetic material powder and a resin may be used. As an example, it is possible to use a flame-retardant noise suppressing sheet characterized by containing (A) 1,000 pts.wt. of flat soft magnetic material powder, (B) 10 to 30 pts.wt. of epoxy resin, (C) 1 to 60 pts.wt. of an epoxy resin curing agent, (D) 0.03 to 1.5 pts.wt. of a hardening accelerator, (E) 45 to 200 pts.wt. of an epoxy group-containing acrylic copolymer of ≥-10°C in Tg (glass transition temperature) and ≥800,000 in weight-average molecular weight containing 2 to 6% by weight of glycidyl (meth) acrylate, (F) 3 to 20 pts.wt. of a dispersant, (G) 30 to 70 pts.wt. of an organic phosphinate compound, and (H) 50 to 90 pts.wt. of metal hydroxide, as disclosed in JP 2009-059752A filed separately by the Applicant.

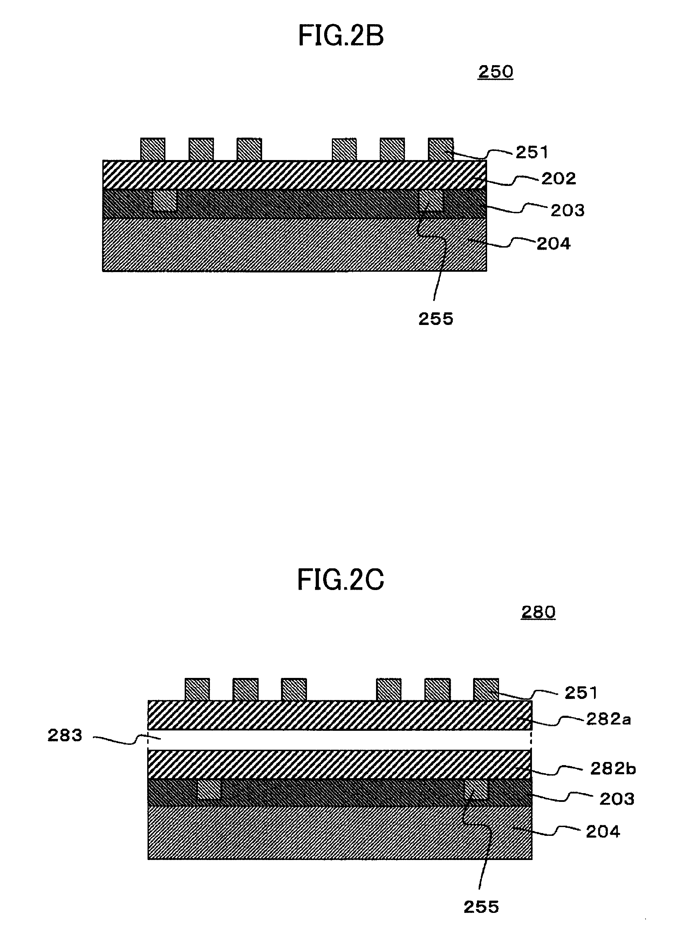

FIG. 2B illustrates a cross-section structure of an antenna sheet for the non-contact charging device (transmitting side) according to one embodiment of the present invention. As illustrated in FIG. 2B, an antenna sheet for the non-contact charging device 250 on the transmitting side comprises, as the constructional members thereof, a resonance coil (-shaped antenna) 251, a substrate 202 and a magnetic sheet 204. More specifically, the antenna sheet 250 comprises the substrate 202 adhered on the magnetic sheet 204 with an adhesive 203, and the resonance coil (-shaped antenna) 251 formed on the substrate 202 by etching or the like. Further, a feed coil (-shaped antenna) 255 is buried in the adhesive 203.

The material for the adhesive 203 or the magnetic sheet 204 is as described above.

FIG. 2C illustrates a cross-section structure of an antenna sheet for the non-contact charging device (transmitting side) according to other embodiment of the present invention. As illustrated in FIG. 2C, an antenna sheet for the non-contact charging device 280 on the transmitting side comprises, as the constructional members thereof, a resonance coil (-shaped antenna) 251, substrates 282a, 282b and a magnetic sheet 204. More specifically, the antenna sheet 280 comprises the substrate 282b adhered on the magnetic sheet 204 with an adhesive 203, and the resonance coil (-shaped antenna) 251 formed by etching or the like on the substrate 282a provided over the substrate 282b across an intervened gap layer 283. Further, a feed coil (-shaped antenna) 255 is buried in the adhesive 203.

In an implementation, the gap layer 283 is filled with Styrofoam.

A difference between the antenna sheets 250 and 280 in terms of their functional effects will now be described. According to an experiment performed by the Inventors, under the condition of 6.78 MHz of resonance frequency in the resonance coil 251, better transmitting efficiency is obtained when the distance between the feed coil and the resonance coil is set closer as with the antenna sheet 250, while under the condition of 13.56 MHz of resonance frequency in the resonance coil 251, better transmitting efficiency is obtained when the gap layer (with a thickness of about 5 mm) is provided between the feed coil 255 and the resonance coil 251 (or between the substrates 282a and 282b) as with the antenna sheet 280.

FIG. 3 illustrates a planar structure of the antenna sheet for the non-contact charging device according to other embodiment of the present invention. As illustrated in FIG. 3, the antenna sheet 200 comprises a substrate 202 and a spiral antenna 201 formed on the substrate 202 by etching or the like. If the antenna 201 is formed on the substrate 202 by thin-film etching or the like, it may be formed on substantially the same plane as the substrate 202, resulting in a thin sheet. Alternatively, the antenna 201 may be formed to be buried in the substrate 202. Further, in FIG. 3, a resistor (R) or a capacitor (C) which is required for the coil-shaped antenna 201 as an electric circuit is implemented by being connected as an external element.

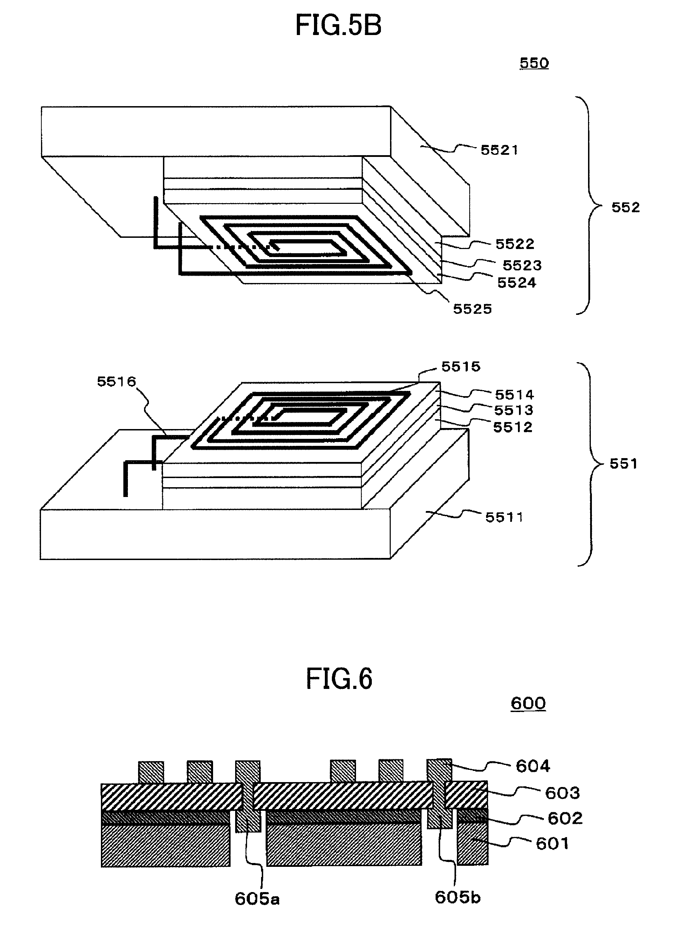

FIG. 5A illustrates an exterior configuration of the non-contact charging device according to one embodiment of the present invention. As illustrated in FIG. 5, the non-contact charging device 500 comprises a transmitting-side device 501 and a receiving-side device 502. The transmitting-side device 501 comprises a similar antenna sheet to that illustrated in FIG. 2A mounted on a transmitting-side control circuit board 5011. Likewise, the receiving-side device 502 comprises a similar antenna sheet to that illustrated in FIG. 2A mounted on a receiving-side control circuit board 5021.

That is, the transmitting-side device 501 comprises an antenna sheet mounted on the transmitting-side control circuit board 5011, wherein the antenna sheet has a substrate 5014 adhered on a magnetic sheet 5012 with an adhesive 5013 and a transmitting coil (-shaped antenna) 5015 formed on the substrate 5014 by etching or the like. Likewise, the receiving-side device 502 comprises an antenna sheet mounted on the receiving-side control circuit board 5021, wherein the antenna sheet has a substrate 5024 adhered on a magnetic sheet 5022 with an adhesive 5023 and a reception coil (-shaped antenna) 5025 formed on the substrate 5024 by etching or the like. Then, in FIG. 5A, the transmitting-side device 501 and the receiving-side device 502 of the non-contact charging device 500 are arranged to allow each antenna plane to be opposed to each other. Further, the winding directions of the antennas of the transmitting-side device 501 and the receiving-side device 502 are inversed to each other.

FIG. 5B illustrates an exterior configuration of the non-contact charging device according to other embodiment of the present invention. As illustrated in FIG. 5B, a non-contact charging device 550 comprises a transmitting-side device 551 and a receiving-side device 552. The receiving-side device 552 comprises a similar antenna sheet to that illustrated in FIG. 2A mounted on a receiving-side control circuit board 5521. That is, the receiving-side device 552 comprises an antenna sheet mounted on the receiving-side control circuit board 5521, wherein the antenna sheet has a substrate 5524 adhered on a magnetic sheet 5522 with an adhesive 5523 and a reception coil (-shaped antenna) 5525 formed on the substrate 5524 by etching or the like.

The transmitting-side device 551 comprises a similar antenna sheet to that illustrated in FIG. 2B mounted on a transmitting-side control circuit board 5511. That is, the transmitting-side device 551 has a substrate 5514 adhered on a magnetic sheet 5512 with an adhesive 5513, and a transmitting coil (-shaped antenna) 5515 formed on the substrate 5514 by etching or the like. A feed coil (-shaped antenna) 5526 is buried in the adhesive 5513, and in FIG. 5B, the opposite ends of the feed coil pulled out from the layer of the adhesive 5513 are connected to a transmitting-side control circuit board 5511. The antenna sheet layer as described above is mounted on the transmitting-side control circuit board 5511.

Then, in FIG. 5B, the transmitting-side device 551 and the receiving-side device 552 of the non-contact charging device 550 are arranged to allow each antenna plane to be opposed to each other. Further, the winding directions of the antennas of the transmitting-side device 551 and the receiving-side device 552 are inversed to each other.

FIG. 6 illustrates a cross-section structure of the antenna sheet for the non-contact charging device according to other embodiment of the present invention. An antenna sheet 600 is characterized by a hole created in a layer consisting of a magnetic sheet, an adhesive and a substrate, and a terminal penetrating from a coil (-shaped antenna) to the underside of the layer, in order to make the wiring between the coil (-shaped antenna) and a control circuit board to be simple and easy.

In FIG. 6, terminals for external connection 605a and 605b are illustrated penetrating from the coil (-shaped antenna) 604 through the substrate 603 and projecting from the hole created in the magnetic sheet 601 and the adhesive 602. The terminals for external connection 605a and 605b allow the electrical connection to a control circuit board provided under the magnetic sheet 601 to be simple and easy.

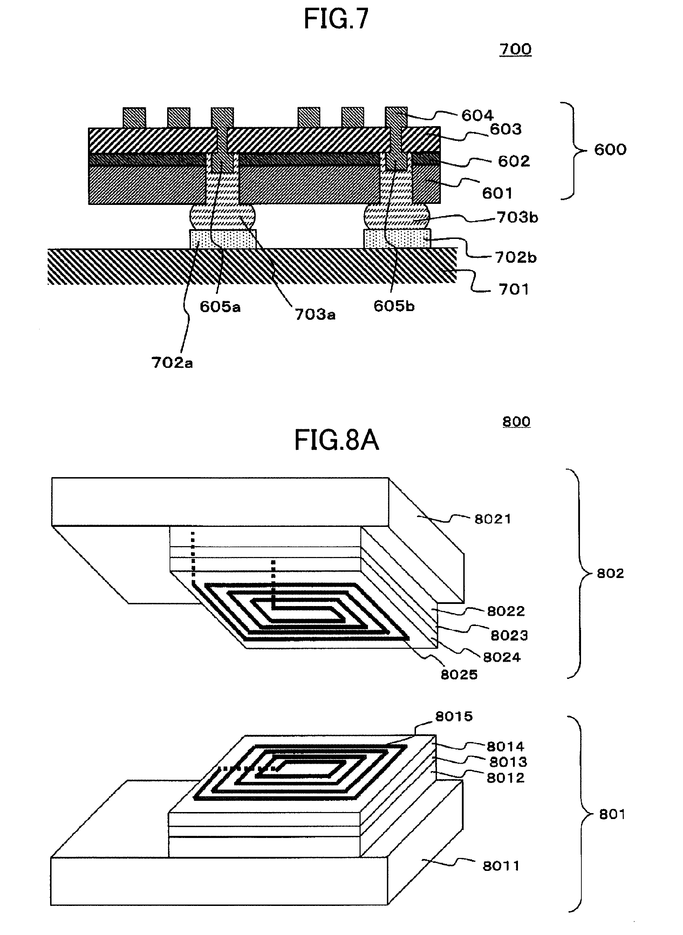

FIG. 7 illustrates a cross-section structure of the non-contact charging device according to other embodiment of the present invention. A non-contact charging device 700 comprises a control circuit board 701 and an antenna sheet 600 connected on the control circuit board 701, and as illustrated in FIG. 7, connection terminals 702a and 702b located on the control circuit board 701 are electrically connected to the terminals for external connection 605a and 605b of the antenna sheet 600 by solders 703a and 703b, respectively.

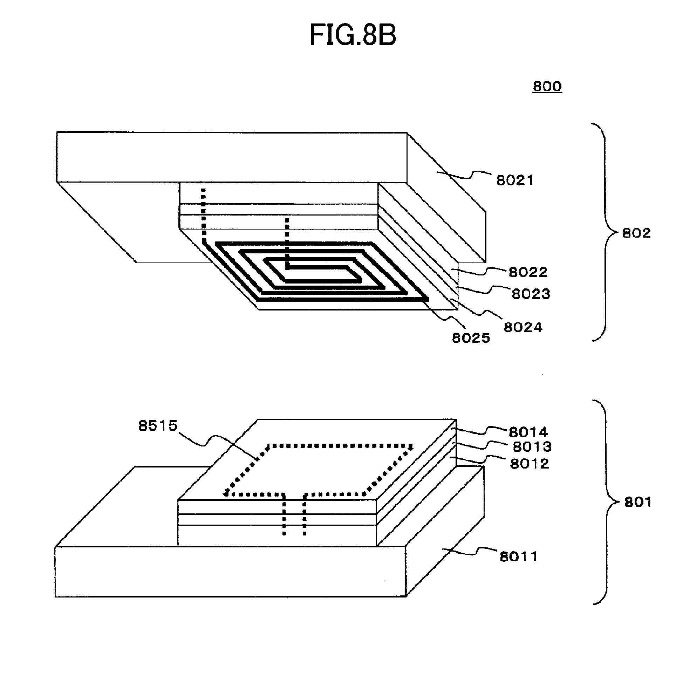

FIGS. 8A and 8B illustrate exterior configurations of the non-contact charging device according to other embodiment of the present invention. A non-contact charging device 800 is an example in which devices similar to those of the non-contact charging device 700 employing the antenna sheet 600 illustrated in FIG. 6 are applied as transmitting-side and receiving-side devices 801 and 802. For convenience of illustration, the transmitting-side device 801 illustrated in FIG. 8A is shown by omitting the illustration of feed antenna to facilitate the understanding of the wiring of a resonance antenna 8015. On the other hand, the transmitting-side device 801 illustrated in FIG. 8B is shown by omitting the illustration of resonance antenna to facilitate the understanding of the wiring of a feed antenna 8515.

In FIG. 8B, the feed antenna 8515 has opposite ends electrically connected from terminals for external connection (not illustrated in FIG. 8B) projecting from holes created in a layer of a magnetic sheet 8012 and an adhesive 8013 (and a substrate 8014 is needed) to connection terminals (not illustrated in FIG. 8B) located on a transmitting-side control circuit board 8011 via solders.

Further, in FIGS. 8A and 8B, the receiving-side device 802 comprises a reception antenna 8025 having opposite ends electrically connected from terminals for external connection (not illustrated in FIGS. 8A and 8B) projecting from holes created in a layer of a magnetic sheet 8022, an adhesive 8023 and a substrate 8024 to connection terminals (not illustrated in FIGS. 8A and 8B) located on a receiving-side control circuit board 8021 via solders.

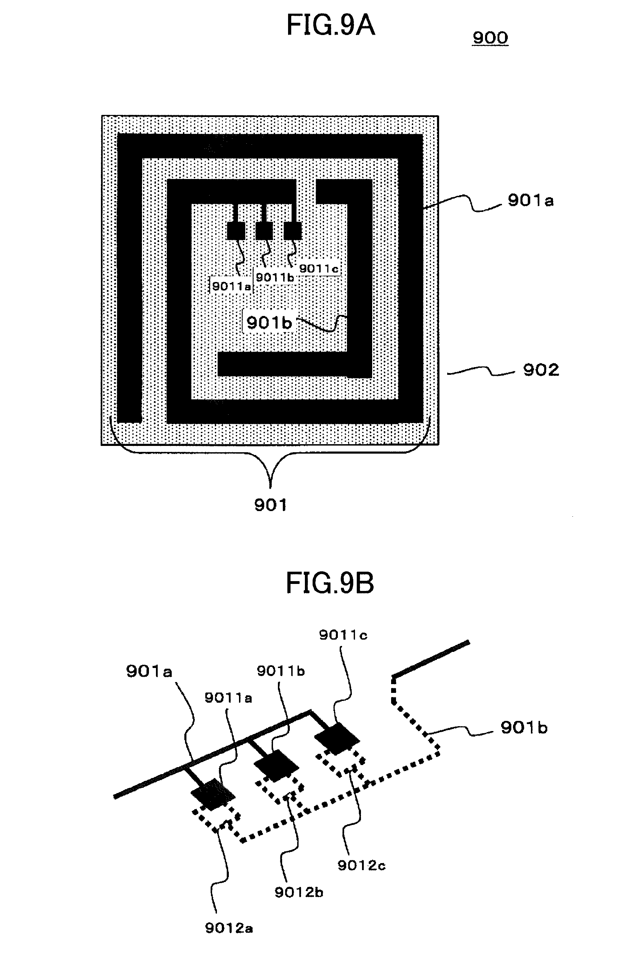

FIG. 9A illustrates a planar structure of the antenna sheet for the non-contact charging device according to other embodiment of the present invention. An antenna sheet 900 includes an antenna 901 wired on a substrate 902 by etching or the like, wherein the antenna 901 comprises an antenna portion 901a having capacitor elements 9011 a to 9011c, and an antenna portion 901 b having capacitor elements 9012a to 9012c (not illustrated in FIG. 9A). While the antenna sheet 200 illustrated in FIG. 3 is described to have a resistor (R) or a capacitor (C), which is required as an electric circuit, implemented by being connected as an external element, the antenna 901 is not required to be connected by an external element because each of the antenna portions 901 a and 901b has capacitor elements.

FIG. 9B illustrates a structure of capacitor elements portion of the antenna portions 901a and 901b in more detail. In FIG. 9B, the antenna portion 901a has capacitor elements 9011a, 9011 b and 9011c, and the antenna portion 901 b has capacitor elements 9012a, 9012b and 9012c, wherein the capacitor elements 9011 a and 9012a serve as a capacitive element. Likewise, the capacitor elements 9011 b and 9012b serve as a capacitive element, and the capacitor elements 9011c and 9012c serve as a capacitive element.

For convenience of explanation, three capacitors are illustrated in FIGS. 9A and 9B. However, the present invention is not limited thereto, but any number of one or more capacitor elements may alternatively be provided as desired.

Further, the capacitor elements illustrated in FIGS. 9A and 9B have an advantage that adjustment of capacitance is easy because the capacitor function is easily eliminated by disconnecting the wiring to the antenna. For example, the capacitance can be easily adjusted by forming extra capacitor elements and disconnecting the capacitor elements one by one while measuring the capacitance until the desired capacitance is obtained.

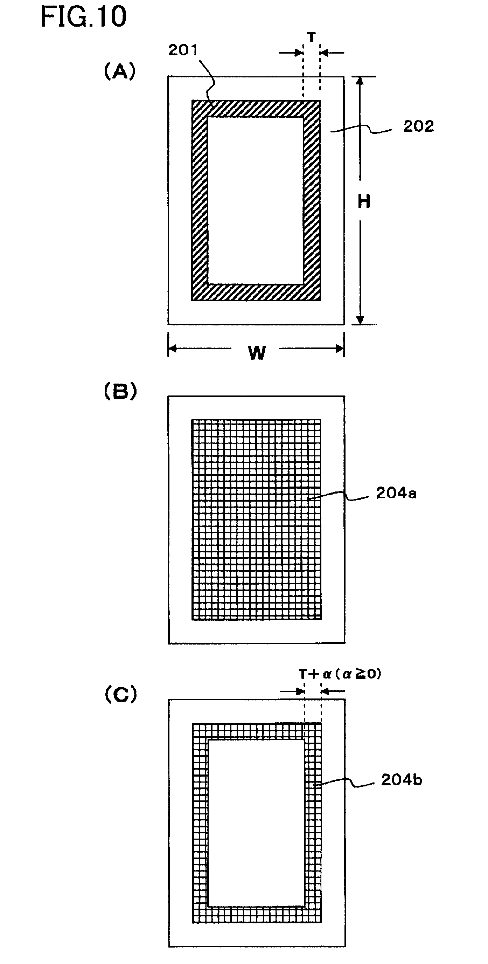

FIG. 10 illustrates a variation in attachment positions and sizes of the magnetic sheet with respect to the antenna sheet for the non-contact charging device (receiving side) according to one embodiment of the present invention. FIG. 10(A) illustrates a coil-shaped antenna 201 being wound in many layers to be wired on a substrate 202 having vertical H and horizontal W lengths. The antenna 201 has a width T as the result of being wound in many layers.

As illustrated in FIG. 2, the magnetic sheet is glued by an adhesive to the underside of the substrate 202 as viewed from FIG. 10, where patterns of the size and shape of the magnetic sheet glued includes a pattern in which the magnetic sheet 204a is glued in such a manner as to entirely cover an outer periphery of the coil-shaped antenna 201 as illustrated in FIG. 10(B), and a pattern in which the hollowed-out annular magnetic sheet 204b is glued in accordance with the shape of the coil-shaped antenna 201 as illustrated in FIG. 10(C). In this case, the ring of the hollowed-out annular magnetic sheet 204b is designed to have a width of the same size as or slightly larger ($+\alpha$) than T.

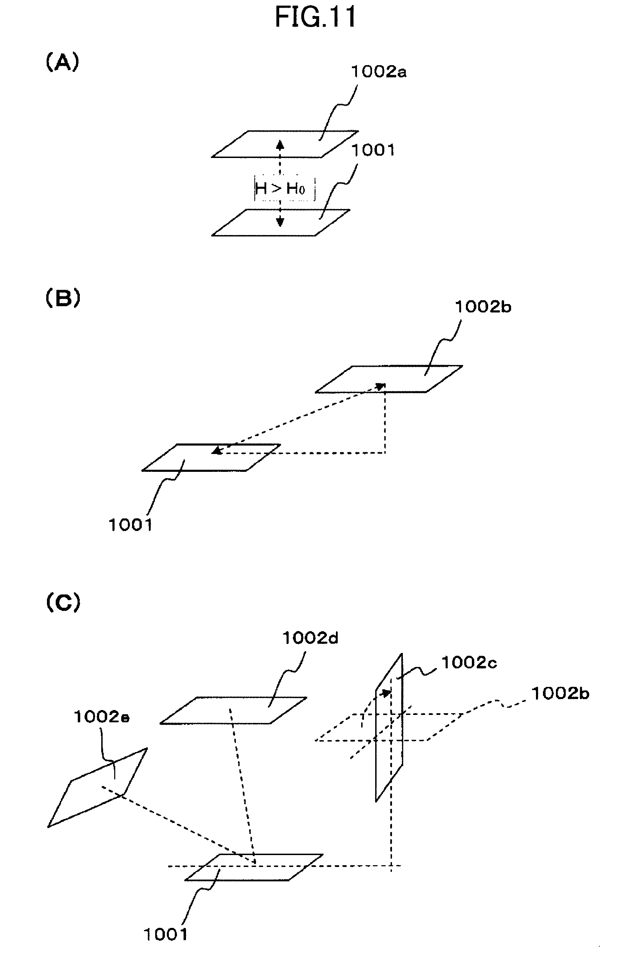

FIG. 11 illustrates a broad range of degree of freedom of sheet arrangements in the non-contact charging device according to other embodiment of the present invention. The non-contact charging device according to the present invention has a characteristic of allowing a high degree of freedom in respect of an arrangement relation between the transmitting-side device and the receiving-side device. For convenience of explanation, the transmitting-side and receiving-side devices are illustrated to be arranged with respective antenna plane being opposed to each other in FIGS. 1, 5A, 5B, 8A and 8B. However, the present invention is not limited thereto, but can efficiently transmit the electricity even if the transmission distance H to the receiving-side device 1002a becomes larger than H0 indicated in FIG. 1 with respect to the transmitting-side device 1001 as illustrated in FIG. 11 (A). Alternatively, the electricity can also be transmitted efficiently even if the receiving-side device 1002b is obliquely translated with respect to the transmitting-side device 1001 as illustrated in FIG. 11 (B), or if the receiving-side device 1002c is arranged to be rotated by approximately 90 degrees from the position of the receiving-side device 1002b with respect to the transmitting-side device 1001 as illustrated in FIG. 11(C).

Further, the present invention has a great advantage that the electricity on the transmitting-side can be simultaneously supplied to a plurality of receiving-side devices (as an example, 1002c, 1002d and 1002e in FIG. 11 (C)) arranged with various distances and angles with respect to the transmitting-side device 1001, although the electricity is distributed depending on the respective distances and angles.

[Resonance condition etc.]

As stated above, the antenna sheet for the non-contact charging device and the charging device using the antenna sheet according to the present invention allow for non-contact charging with high degree of freedom in arrangement. The followings will describe in detail a resonance condition etc. for enabling such a charging.

The basic operation of the non-contact charging device is generally to feed electricity generated in a power transmission device on a transmitting side from a transmitting-side device to a receiving-side device in a non-contact manner by coupling the magnetic fields generated at a transmitting-side resonator for the transmitting-side device having a predetermined resonance frequency f1 and at a receiving-side resonator for the receiving-side device having a predetermined resonance frequency f2 in an electromagnetic field having a frequency environment of 400 kHz to 20 MHz.

Generally, a configuration of the power transmission device comprises a transmitting-side resonator, a transmitter, a power amplifier, a directional coupler, a bandpass filter (as an example, a BPF for travelling wave, a BPF for reflected wave, or the like), a distributor (as an example, a distributor for travelling wave, a distributor for reflected wave, or the like), a computing unit, a low-pass filter, a phase-change detector, an amplitude-difference detection circuit, a smoothing capacitor, a link coil, an impedance-variable element, a control section and the like. However, since the power transmission device in the present invention can employ known components, any detailed description of the power transmission device will be omitted here.

Then, at the transmitting-side resonator, the relation of the following formula (1) is satisfied:

$$f1 = \frac{1}{2\pi\sqrt{L1 \cdot C1}}$$

where f1 is a resonance frequency, L1 is an inductance of a pickup coil, and C1 is a capacitance of a resonance capacitor.

Further, at the receiving-side resonator, the relation of the following formula (2) is satisfied:

$$f2 = \frac{1}{2\pi\sqrt{L2 \cdot C2}}$$

$$(2)$$

where f2 is a resonance frequency, L2 is an inductance of a pickup coil, and C2 is a capacitance of a resonance capacitor.

The electric current extracted in a non-contact manner in the receiving-side device at a pickup coil L2 by electromagnetic induction is controlled by the control section (not illustrated) as a constant current, and subjected to impedance conversion as necessary to feed electricity to a load.

Based on this basic principle, the present invention sets two types of resonance frequencies: 13.56 MHz and 6.78 MHz, and variously sets the resonance capacitor C1 of the transmitting-side (resonance) coil and the resonance capacitor C2 of the receiving-side coil (for which two types including Type 1 and Type 2 are prepared), to thereby verify a condition in which the effect of the present invention as described above can be sufficiently provided. The results are summarized in the Table 1 below.

The receiving-side coil (Type 1) has an outer shape of 60 mm x 60 mm in, the coil has a thickness L of 1 mm, and the coil wires have a spacing S of 0.5 mm therebetween. On the other hand, the receiving-side coil (Type 2) has an outer shape of 30 mm x 40 mm in, the coil has a thickness L of 0.4 mm, and the coil wires have a spacing S of 0.2 mm therebetween. The number of turns of the coil is set to the number by which an inductance satisfying a resonance frequency with respect to the capacitance of the resonance capacitor can be obtained, respectively.

Further, in the verification, a condition in which higher power efficiency is obtained is also examined by gluing various types of magnetic sheets to the receiving-side antenna sheet.

[Table 1]

| Frequency (MHz) | Receiving-side magnetic sheet Thickness (μm) | Transmission (Resonance) coil C1(pF) | Reception coil type 1 C2(pF) | Reception coil type 2 C2(pF) |
|---|---|---|---|---|
| | | LL1 | SL1-1 | RL1-1 |
| 13.56 | Non | 1~5 | 70~100 | |
| | 70 (hollowed-out) | | | |
| | 70 | | | |
| | 200 | | | |
| 6.78 | Non | 8~20 | 70~120 | |
| | 70 (hollowed-out) | | | |
| | 70 | | | |
| | 200 | | | |

As a result of verification, in the case where the magnetic sheet is not used and the resonance frequency is 13.56 MHz, good power feeding efficiency is obtained when the capacitor of the resonance coil has a capacitance C1 of 1 to 5 pF, and the capacitor of the reception coil has a capacitance of 70 to 100 pF for both Type 1 and Type 2.

On the other hand, in the case where the resonance frequency is 6.78 MHz, good power feeding efficiency is obtained when the capacitor of the resonance coil has a capacitance C 1 of 8 to 20 pF, and the capacitor of the reception coil has a capacitance of 70 to 120 pF for both Type 1 and Type 2.

In the case where the magnetic sheet is used, good power feeding efficiency is obtained when the magnetic sheet has a thickness of approximately 70 μm in both of the sheet patterns (FIG. 10(B) and 10(C)) as described with reference to FIG. 10.

Further, when the magnetic sheet is set to have a thickness of approximately 200 μm, leakage magnetic flux on the receiving side can more strongly be inhibited, and higher power feeding efficiency can be obtained.

For the magnetic sheet, those having thickness of approximately 10 to 500 μm can be extensively used.

The relation between the thickness of the magnetic sheet and the feeding efficiency will now be described. In the order of the above experiment, it is considered that the magnetic sheet having larger thickness provides higher feeding efficiency. Further, if the magnetic sheet is thicker, the leakage magnetic flux can be reduced, so that an effect of reducing a negative impact on the control circuit board can be promised.

Further, the thicker the magnetic sheet is, the greater the impact on the coil becomes, resulting in a tendency that the resonance frequency is reduced. Accordingly, in the case of providing a "magnetic body-integrated coil" to which the present invention is applied, the coil can be designed by taking into account the frequency shift caused by the magnetic sheet from a design phase thereof. Thus, the handling becomes advantageously easy relative to a case where a user separately purchases and combines the coil and the magnetic sheet.

[Transmission efficiency in the case of using a plurality of transmitting-side devices]

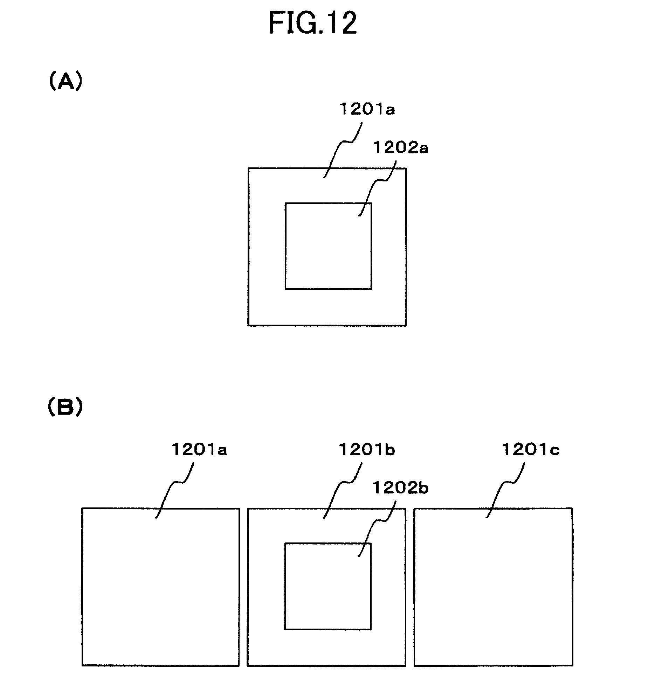

According to the present invention, a plurality of transmitting-side devices can be used. Referring to FIG. 12(A), a transmitting-side device 1201a and a receiving-side device 1202a are opposed to each other at a regular spacing. As an example, in the case of using three transmitting-side devices, transmitting-side devices 1201 a to 1201 c are arranged in side-by-side relation, wherein the receiving-side device 1202a is disposed to be opposed to the transmitting-side device 1201b at a regular spacing as illustrated in FIG. 12(B).

Transmission efficiency from the transmitting-side device to the receiving-side device in each of the arrangements of FIG. 12(A) and 12(B) is summarized in the Table below.

[Table 2]

| | Transmission Efficiency | | |
|---|---|---|---|
| | Transmitting-side device 1201a | Transmitting-side device 1201b | Transmitting-side device 1201c |
| Layout (A) | 51% | - | - |
| Layout (B) | 3.7% | 45% | 3.7% |

In this way, when a plurality of transmitting-side devices are used, the receiving-side device can be simultaneously fed with electricity from all the transmitting-side devices, and for example, when a large number of transmitting-side devices are arranged planarly or sterically, the degree of freedom in arrangement illustrated in FIG. 11 can be highly improved.

In addition, a condition etc. which is obtained by the Inventor through the experiment will now be noted. Where the outer diameter of the reception coil = 0, the distance between the receiving-side device and the transmitting-side device is preferably not less than 0 and not more than $\alpha$, more preferably not less than 0 and not more than 0.75 x $\alpha$, and yet more preferably not less than 0.25 x $\alpha$ and not more than 0.5 x $\alpha$. In this case, the outer diameter of the reception coil $\alpha$ is $\alpha$ = (long side length of outer-most side + short side length of outer-most side)/2 only if the ratio of long side: short side = 1:1 to 2:1 in the case of rectangle. Further, for the relation between the outer diameter of the reception coil $\alpha$ and the outer diameter of the transmitting coil $\beta$, the relation of $\alpha>\beta/3$ and $\alpha<\beta$ x 3 holds.

LIST OF REFERENCE SIGNS

100: non-contact charging device

101: feed sheet (feeding antenna sheet)
1011, 1021, 1031, 202, 282a, 282b: substrate
1012, 255: feed coil (feed coil-shaped antenna)
102, 200: reception sheet (receiving antenna sheet)
1022, 201: reception coil (reception coil-shaped antenna)
103: resonance sheet (resonating antenna sheet)
1032, 251: resonance coil (resonance coil-shaped antenna)
203: adhesive
204, 204a, 204b: magnetic sheet

**Claims**

1. An antenna sheet for a non-contact charging device, usable as a transmitting-side resonator for a transmitting-side device or a receiving-side resonator for a receiving-side device, comprising:

   a substrate; and
   a coil-shaped antenna formed on the substrate, the coil-shaped antenna being configured to function as a pickup coil operable to resonate at a resonant frequency f, when a resonance capacitor is set to have a capacitance C.

2. The antenna sheet as defined in claim 1, wherein the resonant frequency f is 13.56 MHz, the transmitting-side resonator comprises a resonance capacitor having a capacitance of 1 to 5 pF, and the receiving-side resonator comprises a resonance capacitor having a capacitance of 70 to 100 pF.

3. The antenna sheet as defined in claim 1, wherein the resonant frequency f is 6.78 MHz, the transmitting-side resonator comprises a resonance capacitor having a capacitance of 8 to 20 pF, and the receiving-side resonator comprises a resonance capacitor having a capacitance of 70 to 120 pF.

4. The antenna sheet as defined in claim 2 or 3, wherein the substrate of the antenna sheet used as the receiving-side resonator comprises a layer of a magnetic sheet glued by an adhesive on the opposite side of the antenna formed.

5. The antenna sheet as defined in claim 4, wherein the magnetic sheet is glued on the substrate in such a manner as to cover an outer periphery of the coil-shaped antenna.

6. The antenna sheet as defined in claim 4, wherein the magnetic sheet has a hollowed-out annular shape in accordance with a shape of the coil-shaped antenna.

7. The antenna sheet as defined in any one of claims 4 to 6, wherein the layer of the magnetic sheet has a thickness of 10 to 500 $\mu$m.

8. The antenna sheet as defined in any one of claims 4 to 7, comprising an externally-connected terminal penetrating through the substrate and projecting from a hole created in the magnetic sheet and the adhesive.

9. A non-contact charging device comprising:

   a transmitting-side antenna sheet obtained by adhering a first substrate on a first magnetic sheet with an adhesive, forming a resonance coil on the first substrate, and burying a feed coil in the adhesive; and
   a receiving-side antenna sheet obtained by adhering a second substrate on a second magnetic sheet with an adhesive, and forming a reception coil on the second substrate.

10. The non-contact charging device as defined in claim 9, wherein each of the resonance coil and the reception coil has a resonant frequency of 13.56 MHz, the transmitting-side antenna sheet comprises a resonance capacitor having a capacitance of 1 to 5 pF, and the receiving-side antenna sheet comprises a resonance capacitor having a capacitance of 70 to 100 pF.

11. The non-contact charging device as defined in claim 9, wherein each of the resonance coil and the reception coil has a resonant frequency of 6.78 MHz, the transmitting-side antenna sheet comprises a resonance capacitor having a capacitance of 8 to 20 pF, and the receiving-side antenna sheet comprises a resonance capacitor having a capacitance of 70 to 120 pF.

12. The non-contact charging device as defined in any one of claims 9 to 11, wherein the second magnetic sheet is glued on the second substrate in such a manner as to cover an outer periphery of the coil-shaped antenna.

13. The non-contact charging device as defined in any one of claims 9 to 11, wherein the second magnetic sheet has a hollowed-out annular shape in accordance with a shape of the coil-shaped antenna.

14. The non-contact charging device as defined in any one of claims 10 to 13, wherein the layer of the second magnetic sheet has a thickness of 10 to 500 $\mu$m.

15. The non-contact charging device as defined in any one of claims 9 to 14, comprising an externally-connected terminal projecting from a hole created in the first magnetic sheet and the adhesive.

# FIG.1

100

<transmitting side>                    <receiving side>

102

101          103                    1021

1011                              1022
        1031
     1012    1032

C2

C1
R1=50Ω

transmission distance H₀

between coils
0.5mm

Z=50Ω

# FIG.2A

200

201
202
203
204

# FIG.2B

250

251
202
203
204

255

# FIG.2C

280

251
282a

283

282b
203
204

255

# FIG.3

200

201

202

# FIG.4

204

2042

2041

# FIG.5A

500

5021

502

5022
5023
5024
5025

5015
5014
5013
5012

501

5011

# FIG.5B

550

552
5521
5522
5523
5524
5525

5516
5515
5514
5513
5512
5511
551

# FIG.6

600

604
603
602
601

605a          605b

## FIG.7

700

604
603
602
601
} 600

703b
702b
701

605a
703a
605b

702a

800

## FIG.8A

8021
8022
8023
8024
8025
} 802

8015
8014
8013
8012
8011
} 801

# FIG.8B

800

8021

802

8022
8023
8024
8025

8515

8014
8013
8012

801

8011

# FIG.9A

900

901a

902

901

# FIG.9B

9011c

901a

9011b

9011a

901b

9012c

9012b

9012a

# FIG.10

(A)

(B)

(C)

# FIG.11

(A)

1002a

1001

$H > H_0$

(B)

1002b

1001

(C)

1002d

1002c

1002b

1002e

1001

# FIG.12

(A)

1201a

1202a

(B)

1201a          1201b          1201c

1202b

**INTERNATIONAL SEARCH REPORT**

| International application No. |
|---|
| PCT/JP2013/063435 |

A. CLASSIFICATION OF SUBJECT MATTER
*H02J17/00*(2006.01)i, *H01F38/14*(2006.01)i, *H01Q7/00*(2006.01)i, *H02J7/00* (2006.01)i, *H05K9/00*(2006.01)i

According to International Patent Classification (IPC) or to both national classification and IPC

B. FIELDS SEARCHED

Minimum documentation searched (classification system followed by classification symbols)
H02J17/00, H01F38/14, H01Q7/00, H02J7/00, H05K9/00

Documentation searched other than minimum documentation to the extent that such documents are included in the fields searched
Jitsuyo Shinan Koho          1922-1996   Jitsuyo Shinan Toroku Koho   1996-2013
Kokai Jitsuyo Shinan Koho    1971-2013   Toroku Jitsuyo Shinan Koho   1994-2013

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y<br>A | WO 2010/137495 A1  (Nippon Tecmo Co., Ltd.),<br>02 December 2010 (02.12.2010),<br>paragraphs [0024] to [0045]; fig. 2 to 3, 6 to 7<br>(Family: none) | 1-3<br>4-8<br>9-15 |
| Y | JP 2007-317914 A  (Aska Electron Co., Ltd.),<br>06 December 2007 (06.12.2007),<br>paragraphs [0014] to [0017]; fig. 1 to 6<br>(Family: none) | 4-8 |
| A | JP 2008-508842 A  (JC Protek Co., Ltd.),<br>21 March 2008 (21.03.2008),<br>entire text; all drawings<br>& US 2008/0266748 A1    & EP 1779550 A<br>& WO 2006/011769 A1    & KR 10-2004-0072581 A<br>& CN 101023600 A | 1-15 |

☐ Further documents are listed in the continuation of Box C.        ☐ See patent family annex.

| * | Special categories of cited documents: |
|---|---|
| "A" | document defining the general state of the art which is not considered   to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search<br>17 July, 2013 (17.07.13) | Date of mailing of the international search report<br>30 July, 2013 (30.07.13) |
|---|---|
| Name and mailing address of the ISA/<br>Japanese Patent Office | Authorized officer |
| Facsimile No. | Telephone No. |

Form PCT/ISA/210 (second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 11103531 A
- JP 2012060812 A
- JP 8019185 A
- JP 2009059752 A